(19) Europäisches Patentamt
European Patent Office
Office européen des brevets

(11) **EP 2 172 981 B1**

(12) **FASCICULE DE BREVET EUROPEEN**

(45) Date de publication et mention
de la délivrance du brevet:
**25.12.2013 Bulletin 2013/52**

(51) Int Cl.:
**H01L 31/072** *(2012.01)* **H01L 31/065** *(2012.01)*
**H01L 31/075** *(2012.01)* **H01L 31/20** *(2006.01)*

(21) Numéro de dépôt: **09171557.3**

(22) Date de dépôt: **29.09.2009**

(54) **Cellule photovoltaïque à hétérojonction à deux dopages et procédé de fabrication**

Fotovoltaikzelle mit Heteroübergang mit zwei Dotierungen und Herstellungsverfahren

Double-doped photovoltaic cell with heterojunction and manufacturing method

(84) Etats contractants désignés:
**AT BE BG CH CY CZ DE DK EE ES FI FR GB GR
HR HU IE IS IT LI LT LU LV MC MK MT NL NO PL
PT RO SE SI SK SM TR**

(30) Priorité: **02.10.2008 FR 0856669**

(43) Date de publication de la demande:
**07.04.2010 Bulletin 2010/14**

(73) Titulaire: **Commissariat à l'Énergie Atomique
et aux Énergies Alternatives
75015 Paris (FR)**

(72) Inventeur: **Ribeyron, Pierre-Jean
38330, SAINT ISMIER (FR)**

(74) Mandataire: **Augarde, Eric
BREVALEX
56 Boulevard de l'Embouchure,
Bât. B
B.P. 27519
31075 Toulouse Cedex 2 (FR)**

(56) Documents cités:
**US-A1- 2004 182 433 US-A1- 2008 023 068
US-B2- 6 670 542**

• **SAWADA T ET AL: "HIGH-EFFICIENCY A-SI/C-SI
HETEROJUNCTION SOLAR CELL", 5 décembre
1994 (1994-12-05), WORLD CONFERENCE ON
PHOTOVOLTAIC ENERGY. WAIKOLOA, DEC. 5 -
9, 1994; [WORLD CONFERENCE ON
PHOTOVOLTAIC ENERGY], NEW YORK, IEEE,
US, PAGE(S) 1219 - 1226, XP000680063, ISBN:
978-0-7803-1460-3 * le document en entier ***

## Description

### DOMAINE TECHNIQUE

La présente invention concerne de manière générale le domaine des cellules photovoltaïques et plus particulièrement celui des cellules photovoltaïques à hétérojonction de type amorphe/cristallin.

### ÉTAT DE LA TECHNIQUE ANTÉRIEURE

Une cellule photovoltaïque est généralement basée sur une jonction entre un semi-conducteur de type P et un semi-conducteur de type N. On rappelle que dans une telle cellule les photons incidents génèrent dans le semi-conducteur des paires électron-trou séparés ensuite par le champ électrique présent dans la zone de charge d'espace. Les porteurs de charge ainsi séparés sont collectés par des électrodes de collection disposées sur les faces avant et arrière de la cellule.

Parmi les cellules photovoltaïques, on distingue classiquement celles à homojonction, où les semi-conducteurs constituant la jonction sont des matériaux de composition et de structure atomique identiques, et celles à hétérojonction, où ces semi-conducteurs sont des matériaux de composition et/ou de structure atomique différente(s).

Un cas particulier de cellule photovoltaïque à hétérojonction concerne une jonction entre un semi-conducteur monocristallin d'un premier type de conductivité et une couche amorphe du même semi-conducteur, d'un second type de conductivité opposé au premier.

Les cellules photovoltaïques à hétérojonction silicium amorphe (a-Si)/ silicium monocristallin (mono-Si) ou silicium amorphe (a-Si)/ silicium polycristallin (poly-Si) ont fait l'objet de recherches considérables ces dernières années. Un des principaux axes de recherche porte sur l'amélioration du rendement de la conversion photoélectrique, rendement limité notamment par la recombinaison des paires électrons-trou au niveau de l'interface. En effet, les joints entre grains du silicium polycristallin ou les défauts du silicium amorphe créent des états localisés dans la bande interdite et constituent des sites de recombinaison des paires électron-trou.

Une structure de cellule photovoltaïque à hétérojonction a-Si/mono-Si ou poly-Si permettant de réduire le taux de recombinaison des porteurs a été proposée dans le document US-B-5213628 et est illustrée en Fig. 1A. Cette cellule, 100, comprend entre le substrat monocristallin (ou polycristallin), 110, de type N, et la couche de silicium amorphe, 120, de type P, une fine couche de silicium intrinsèque, 125, d'une épaisseur de moins de 250Å. La couche de silicium amorphe intrinsèque étant de meilleure qualité qu'une couche de silicium amorphe dopé, le taux de recombinaison y est plus faible et par conséquent le rendement de conversion photoélectrique de la cellule est plus élevé.

La face supérieure de la couche est classiquement recouverte d'une couche conductrice transparente, 130, par exemple en ITO (*Indium Tin Oxide*), sur laquelle sont disposées des électrodes de collection 140. La couche d'ITO, 130, est exposée à la lumière. La face inférieure du substrat est également recouverte par une électrode arrière, 180, par exemple en aluminium.

En dehors de la zone de charge d'espace à la jonction PN où le transport des porteurs est essentiellement dû au champ électrique, le transport au sein du substrat est gouverné par la diffusion. Dans ce cas, les porteurs majoritaires et minoritaires ne sont plus efficacement séparés et une recombinaison peut intervenir au niveau de l'électrode arrière. Afin d'y remédier, il est connu de déposer sur la face arrière du substrat une couche fortement dopée, de même type de conduction que celui-ci. Le champ créé à l'interface entre cette couche dopée et le substrat, encore dénommé BSF (*Back Surface Field*), renvoie les porteurs minoritaires vers la jonction PN et diminue par conséquent le taux de recombinaison au niveau de l'électrode arrière.

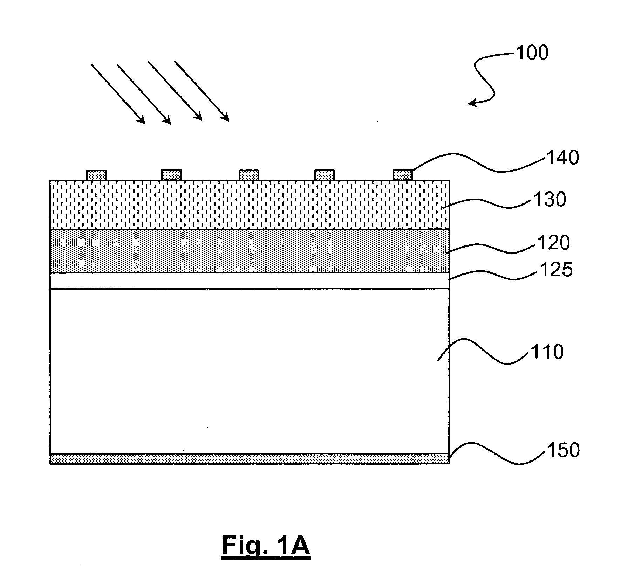

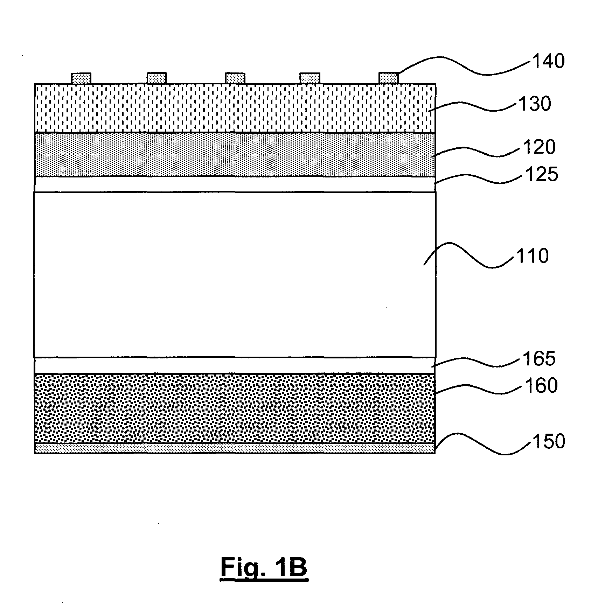

Un exemple de cellule photovoltaïque à hétérojonction et à champ BSF est décrit dans le document US-B-5705828, ainsi que dans le document US-B-6670542, et est schématiquement illustré en Fig. 1B. Les éléments identiques à ceux de la Fig. 1A sont désignés par les mêmes numéros de référence. La structure de la cellule diffère de celle de la Fig. 1A en ce qu'une couche de silicium amorphe dopé $N^+$, 160, est présent sur la face arrière du substrat. Comme pour la face avant, le taux de recombinaison à l'interface avec le substrat peut être réduit en intercalant une couche de a-Si intrinsèque, 165, de 20 à 400 Å entre le substrat et la couche a-Si dopé, 160.

Le dépôt des couches de a-Si 125 et 265 sur le substrat est réalisé à relativement faible température. Il est par conséquent difficile d'éliminer complètement l'eau et les matières organiques présentes sur le substrat avant le dépôt. Il en résulte que des impuretés, majoritairement de l'oxygène, sont présentes aux interfaces entre ces couches et le substrat. Pour compenser le dopage parasite dû à ces impuretés de type N, la demande EP-A-1320134 propose d'incorporer une quantité minime de dopant P (du bore) à ces interfaces.

Bien que cette technique permette d'améliorer la tension en circuit ouvert de la cellule grâce à une passivation des états de surface aux interfaces entre les couches 125, 165 et le substrat, elle est relativement complexe dans la mesure où elle nécessite la réalisation de trois couches distinctes de silicium amorphe sur chacune des faces du substrat. En outre, l'ajout d'une faible quantité de dopant au niveau des interfaces est difficile à contrôler. Enfin, le facteur de forme (paramètre FF ou *Fill Factor*) d'une telle cellule n'est pas très bon. On rappelle que le paramètre FF donne l'écart de la caractéristique réelle de la cellule à une caractéristique idéale rectangulaire. Plus précisément, il est défini comme le rapport

$$FF = \frac{P_{opt}}{I_{cc}V_{co}}$$ où $P_{opt}$ est la puissance fournie par la cellule au point optimal de la caractéristique (produit tension courant maximal), $I_{cc}$ est le courant de court-circuit et $V_{co}$ est la tension de circuit ouvert.

Un premier but de la présente invention est de proposer une structure de cellule photovoltaïque à hétérojonction de type amorphe/cristallin, à champ BSF ou non, présentant une faible densité d'états de surface à l'interface et qui soit plus facilement réalisable que dans l'état de la technique.

Un second but de la présente invention est d'améliorer le facteur de forme de la caractéristique de la cellule tout en préservant une valeur élevée de tension en circuit ouvert.

## EXPOSÉ DE L'INVENTION

La présente invention est définie par une cellule photovoltaïque comprenant une hétérojonction entre un substrat semi-conducteur cristallin d'un premier type de conductivité et une première couche amorphe, sur une première face du substrat, de même matériau semi-conducteur et d'un second type de conductivité, opposé au premier et présentant un niveau de dopage compris entre $1.\ 10^{19}$ et $1.\ 10^{22}$ atomes/cm$^3$, la seconde face du substrat, opposée à la première face, étant recouverte par une troisième couche amorphe, de même matériau que le substrat et de même type de conductivité, avec un niveau de dopage compris entre $1.\ 10^{19}$ et $1.\ 10^{22}$ atomes/cm$^3$. Cette cellule comprend en outre une seconde couche amorphe de même type de conductivité que la première couche et présentant un niveau de dopage compris entre $1.\ 10^{16}$ et $1.\ 10^{18}$ atomes/cm$^3$, ladite seconde couche étant déposée directement sur la première face du substrat et étant recouverte par ladite première couche.

Selon une première variante, le dopage au sein des première et seconde couches est graduel, le niveau de dopage croissant dans une direction allant de la seconde couche vers la première couche.

Selon une seconde variante, le niveau de dopage dans chacune des première et seconde couches est constant.

La première couche a typiquement une épaisseur inférieure à 50 nm et la seconde couche, une épaisseur inférieure à 10 nm.

Avantageusement, selon un second mode de réalisation, la cellule photovoltaïque comprend en outre une quatrième couche amorphe, de même matériau semi-conducteur que le substrat et du même premier type de conductivité, ladite quatrième couche étant déposée directement sur la seconde face du substrat et étant recouverte par ladite troisième couche.

Selon une première variante du second mode de réalisation, le dopage au sein des troisième et quatrième couches est graduel, le niveau de dopage croissant dans une direction allant de la quatrième couche vers la troisième couche.

Selon une seconde variante du second mode de réalisation, le niveau de dopage dans chacune des troisième et quatrième couches est constant.

Typiquement, la troisième couche a une épaisseur inférieure à 50 nm et la quatrième couche a une épaisseur inférieure à 10nm.

Avantageusement, ladite première couche est recouverte d'une première couche d'oxyde transparent conducteur sur laquelle sont disposées des premières électrodes de collecte.

De manière similaire, ladite troisième couche peut être recouverte d'une seconde couche d'oxyde transparent conducteur sur laquelle sont disposées des secondes électrodes de collecte.

## BRÈVE DESCRIPTION DES DESSINS

D'autres caractéristiques et avantages de l'invention apparaîtront à la lecture d'un mode de réalisation préférentiel de l'invention fait en référence aux figures jointes parmi lesquelles :

La Fig. 1A représente schématiquement une première structure de cellule photovoltaïque connue de l'état de la technique ;
La Fig. 1B représente schématiquement une seconde structure de cellule photovoltaïque connue de l'état de la technique ;
La Fig. 2A représente schématiquement une structure de cellule photovoltaïque selon un premier mode de réalisation de l'invention ;
La Fig. 2B représente schématiquement une structure de cellule photovoltaïque selon un second mode de réalisation de l'invention.

## EXPOSÉ DÉTAILLÉ DE MODES DE RÉALISATION PARTICULIERS

On considère à nouveau une structure de cellule photovoltaïque à hétérojonction de type amorphe/cristallin. Une telle cellule comprend un substrat semi-conducteur poly- ou monocristallin, typiquement du silicium monocristallin, d'un premier type de conductivité, sur lequel on a déposé une couche du même semi-conducteur en phase amorphe, typiquement du a-Si, d'un second type de conductivité opposé au premier.

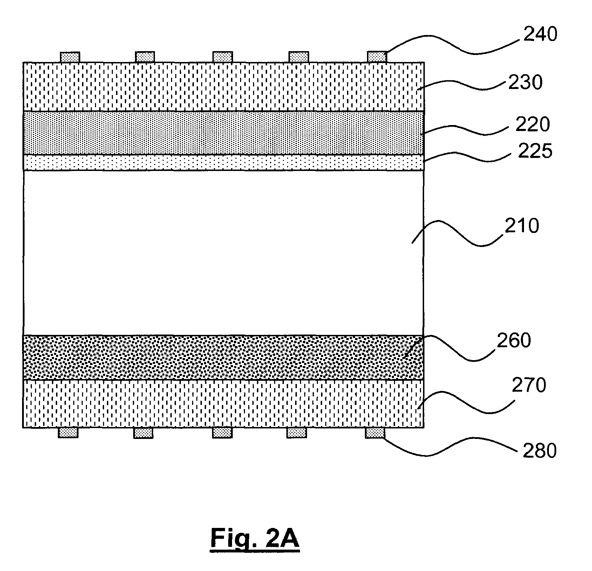

La Fig. 2A illustre la structure d'une cellule photovoltaïque selon un premier mode de réalisation de l'invention.

Le substrat semi-conducteur cristallin, par exemple une tranche de silicium monocristallin de type N, est désigné par 210. L'épaisseur du substrat 210 est de l'ordre de quelques centaines de microns.

La couche de semi-conducteur amorphe, de type opposé à celui du substrat, par exemple du a-Si dopé P$^+$, est désignée par 220. Le niveau de dopage de cette première couche amorphe 220 est compris entre 1. 10$^{19}$ et 1. 10$^{22}$ at/cm$^3$ et son épaisseur est typiquement de 6 à 20 nm et de manière plus générale inférieure à 50 nm.

A la différence de l'état de la technique, une seconde couche amorphe, 225, faiblement dopée et de même type que la première, est directement déposée sur le substrat, avant le dépôt de la couche amorphe 220. Le niveau de dopage de la seconde couche amorphe est compris entre 1. 10$^{16}$ et 1. 10$^{18}$ at/cm$^3$, c'est-à-dire sensiblement inférieur aux niveaux de dopage couramment utilisés, on parle alors conventionnellement de couche microdopée. L'épaisseur de la couche 225 est typiquement comprise entre 2 et 4 nm et de manière plus générale inférieure à 10 nm.

La seconde couche amorphe microdopée, 225, présente un double intérêt. Tout d'abord, par son faible niveau de dopage, elle permet d'obtenir une faible densité d'états localisés et donc un faible taux de recombinaison des porteurs à l'interface ainsi qu'une valeur de $V_{co}$ élevée, à l'instar d'une couche amorphe intrinsèque. En outre, la couche amorphe microdopée présente une conductivité sensiblement plus élevée qu'une couche intrinsèque, ce qui réduit la résistance série de la cellule et améliore sensiblement son facteur de forme.

La couche amorphe 220 est recouverte d'une couche d'oxyde transparent conducteur, 230, par exemple de l'ITO (*Indium Tin Oxide*). Une électrode interdigitée 240, par exemple en argent, permet de collecter les porteurs majoritaires (ici les trous) à la surface supérieure de la cellule. Cette surface supérieure est exposée au rayonnement lumineux.

La face inférieure du substrat 210 est recouverte d'une électrode arrière 280, éventuellement après dépôt d'une troisième couche 260, de même matériau amorphe que le substrat et de même type de conductivité (a-Si dopée N$^+$) avec un niveau de dopage de 10$^{19}$ à 10$^{22}$ at/cm$^3$, pour assurer une bonne collecte des porteurs majoritaires, puis d'une couche d'oxyde transparent conducteur, 270, par exemple de l'ITO. La troisième couche a typiquement une épaisseur comprise entre 12 et 30 nm. La couche d'ITO a par exemple une épaisseur comprise entre 75 et 100 nm.

Selon une première variante, le niveau de dopage est constant au sein de chacune des couches amorphes, le niveau de dopage dans la première couche amorphe étant, comme on l'a dit, sensiblement supérieur à celui de la seconde couche amorphe, directement en contact avec le substrat.

Selon une seconde variante, le niveau de dopage est graduel à travers ces deux couches et croît dans la direction allant de la seconde couche amorphe, 225, à la première couche amorphe, 220. Cette seconde variante est avantageuse dans la mesure où le gradient de dopage crée dans ces couches un champ électrique permettant d'extraire plus facilement les porteurs majoritaires (ici les trous) et s'opposant à la diffusion des porteurs minoritaires (les électrons). La séparation des porteurs de charges réduit encore davantage le taux de recombinaison, en particulier au niveau de la couche conductrice 230. En outre, la partie supérieure de la première couche amorphe étant la plus fortement dopée, un bon contact ohmique peut être obtenu avec la couche conductrice 230.

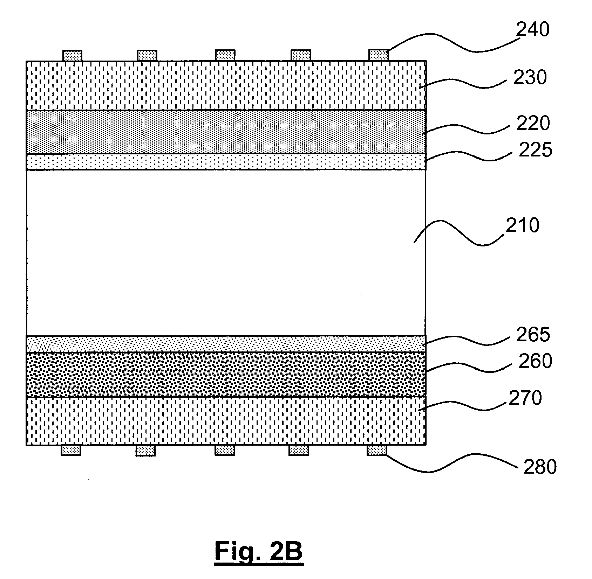

La Fig. 2B illustre la structure d'une cellule photovoltaïque selon un second mode de réalisation de l'invention. Les éléments identiques à ceux de la Fig. 2A sont désignés par les mêmes numéros de référence.

Ce second mode de réalisation diffère du premier en ce qu'il comporte une quatrième couche amorphe microdopée, 265, et de même type que la troisième, ici une couche a-Si dopée N, est déposée directement sur la face arrière du substrat, avant la couche amorphe 260. Le niveau de dopage de la quatrième couche amorphe est compris entre 1. 10$^{16}$ et 1. 10$^{18}$ atomes/cm$^3$ et son épaisseur est typiquement comprise entre 2 et 4 nm.

Par rapport à la configuration connue de l'état de la technique où la couche amorphe fortement dopée, générant le champ BSF, est directement en contact avec la face arrière, la présente structure permet d'obtenir une plus faible densité d'états à l'interface avec le substrat , à l'instar d'une couche intrinsèque, d'où un faible taux de recombinaison des porteurs. En revanche, la quatrième couche étant de conductivité plus élevée qu'une couche amorphe intrinsèque, le facteur de forme de la cellule s'en trouve amélioré.

La face inférieure de la couche amorphe 260 est recouverte d'une électrode de collecte arrière 280, éventuellement après dépôt d'une couche d'oxyde transparent conducteur, 270, par exemple de l'ITO. Cette dernière a par exemple une épaisseur comprise entre 75 et 100 nm.

Selon une première variante du second mode de réalisation, le niveau de dopage est constant au sein de chacune des couches amorphes, le niveau de dopage dans la troisième couche amorphe étant sensiblement supérieur à celui de la quatrième couche amorphe, directement en contact avec le substrat.

Selon une seconde variante du second mode de réalisation, le niveau de dopage est graduel à travers les quatrième et troisième couches. Plus précisément, il croît dans la direction allant de la quatrième couche amorphe, 265, à la troisième couche amorphe, 260. Cette seconde variante présente par rapport à la première variante les mêmes avantages que ceux exposés dans le cadre du premier mode de réalisation, à savoir une extraction plus efficace des porteurs majoritaires (ici des électrons) et un renvoi vers la jonction des porteurs minoritaires (ici les trous) ayant diffusé en direction de l'électrode de collecte, d'où là encore un plus faible taux de recombinaison des porteurs et une valeur de $V_{co}$ plus élevée.

Un exemple de réalisation d'une cellule photovoltaïque selon le second mode de réalisation est donné ci-après.

Le substrat utilisé est une tranche de silicium monocristallin de type N de 250 μm d'épaisseur et de conductivité 2 Ω.cm préalablement texturé, nettoyé et désoxydé dans du HF.

Les seconde et première couches de silicium amorphes sont successivement déposées sur une face du substrat ainsi préparé. Le dépôt est réalisé par dépôt chimique en phase vapeur assisté par plasma (PECVD pour *Plasma Enhanced Chemical Vapor Deposition*). L'épaisseur de la seconde couche est de 3 nm et celle de la première couche de 7 nm.

Le dopage P de la seconde couche amorphe (microdopée), réalisé par introduction de diborane ($B_2H_6$) dans l'enceinte de dépôt plasma, est de $5. 10^{17}$ atomes de Bore/$cm^3$ et celui, $P^+$, de la première couche est de $3. 10^{20}$ atomes de Bore/$cm^3$ (dopage moyen).

Sur l'autre face du substrat, on dépose successivement la quatrième et la troisième couches amorphes par PECVD. L'épaisseur de la quatrième couche est de 4 nm et celle de la troisième couche, de 20 nm.

Le dopage de ces deux couches est réalisé par l'introduction de phosphine ($PH_3$) dans l'enceinte. Le niveau de dopage (constant) de la quatrième couche (microdopée) est de $1. 10^{17}$ atomes/$cm^3$ et celui de la troisième couche de $1. 10^{20}$ atomes/$cm^3$.

Des couches conductrices transparentes en ITO sont ensuite déposées par pulvérisation cathodique (sputtering) et les électrodes de collecte sont réalisées par sérigraphie avec de la pâte dite « basse température ».

La cellule photovoltaïque ainsi obtenue montre une augmentation de la tension $V_{co}$ de 50 mV, du courant $I_{cc}$ de 1 mA/$cm^2$ ainsi qu'un maintien de la valeur du facteur de forme par rapport à une cellule d'épaisseur équivalente mais dépourvue de couches microdopées.

## Revendications

1. Cellule photovoltaïque comprenant une hétérojonction entre un substrat semi-conducteur cristallin (210) d'un premier type de conductivité et une première couche amorphe (220), sur une première face du substrat, de même matériau semi-conducteur et d'un second type de conductivité, opposé au premier et présentant un niveau de dopage compris entre $1. 10^{19}$ et $1. 10^{22}$ atomes/$cm^3$, la seconde face du substrat, opposée à la première face, étant recouverte par une troisième couche amorphe (260), de même matériau que le substrat et de même type de conductivité, avec un niveau de dopage compris entre $1. 10^{19}$ et $1. 10^{22}$ atomes/$cm^3$, **caractérisée en ce qu'**elle comprend en outre une seconde couche amorphe (225) de même type de conductivité que la première couche et présentant un niveau de dopage compris entre $1. 10^{16}$ et $1. 10^{18}$ atomes/$cm^3$, ladite seconde couche étant déposée directement sur la première face du substrat et étant recouverte par ladite première couche.

2. Cellule photovoltaïque selon la revendication 1, **caractérisée en ce que** le dopage au sein des première et seconde couches est graduel, le niveau de dopage croissant dans une direction allant de la seconde couche vers la première couche.

3. Cellule photovoltaïque selon la revendication 1, **caractérisée en ce que** le niveau de dopage dans chacune des première et seconde couches est constant.

4. Cellule photovoltaïque selon l'une des revendications précédentes, **caractérisée en ce que** la première couche a une épaisseur inférieure à 50 nm et la seconde couche a une épaisseur inférieure à 10 nm.

5. Cellule photovoltaïque selon l'une des revendications précédentes, **caractérisée en ce qu'**elle comprend en outre une quatrième couche amorphe (265), de même matériau semi-conducteur que le substrat et du même premier type de conductivité, ladite quatrième couche étant déposée directement sur la seconde face du substrat (210) et étant recouverte par ladite troisième couche.

6. Cellule photovoltaïque selon la revendication 5, **caractérisée en ce que** le dopage au sein des troisième et quatrième couches est graduel, le niveau de dopage croissant dans une direction allant de la quatrième couche vers la troisième couche.

7. Cellule photovoltaïque selon la revendication 5, **caractérisée en ce que** le niveau de dopage dans chacune des troisième et quatrième couches est constant.

8. Cellule photovoltaïque selon l'une des revendications 5 à 7, **caractérisée en ce que** la troisième couche a une épaisseur inférieure à 50 nm et la quatrième couche a une épaisseur inférieure à 10nm.

9. Cellule photovoltaïque selon l'une des revendications précédentes, **caractérisée en ce que** ladite première couche est recouverte d'une première couche d'oxyde transparent conducteur (230) sur laquelle sont disposées des premières électrodes de collecte (240).

10. Cellule photovoltaïque selon l'une des revendications précédentes,- **caractérisée en ce que** ladite troisième couche est recouverte d'une seconde couche d'oxyde transparent conducteur (270) sur laquelle sont disposées des secondes électrodes de collecte (280).

**Patentansprüche**

1. Photovoltaikzelle, umfassend einen Heteroübergang zwischen einem kristallinen Halbleitersubstrat (210) eines ersten Leitfähigkeitstyps und einer ersten amorphen Schicht (220) auf einer ersten Fläche des Substrats aus dem gleichen Halbleitermaterial und von einem zweiten Leitfähigkeitstyp, der dem ersten entgegengesetzt ist, und die ein zwischen $1.10^{19}$ und $1.10^{22}$ Atome/cm$^3$ enthaltenes Dotierungsniveau aufweist, wobei die zweite Fläche des Substrats, die der ersten Fläche gegenüberliegt, mit einer dritten amorphen Schicht (260) aus dem gleichen Material wie das Substrat und vom gleichen Leitfähigkeitstyp bedeckt ist, mit einem zwischen $1.10^{19}$ und $1.10^{22}$ Atome/cm$^3$ enthaltenen Dotierungsniveau, **dadurch gekennzeichnet, dass** sie ferner eine zweite amorphe Schicht (225) vom gleichen Leitfähigkeitstyp wie die erste Schicht umfasst, die ein zwischen $1.10^{16}$ und $1.10^{18}$ Atome/cm$^3$ enthaltenes Dotierungsniveau aufweist, wobei die zweite Schicht direkt auf der ersten Fläche des Substrats aufgebracht und durch die erste Schicht bedeckt ist.

2. Photovoltaikzelle nach Anspruch 1, **dadurch gekennzeichnet, dass** die Dotierung in der ersten und der zweiten Schicht graduell ist, wobei das Dotierungsniveau in einer Richtung zunimmt, die von der zweiten Schicht zur ersten Schicht hin verläuft.

3. Photovoltaikzelle nach Anspruch 1, **dadurch gekennzeichnet, dass** das Dotierungsniveau in jeder von der ersten und zweiten Schicht konstant ist.

4. Photovoltaikzelle nach einem der vorhergehenden Ansprüche, **dadurch gekennzeichnet, dass** die erste Schicht eine dicke von weniger als 50 nm hat, und die zweite Schicht eine Dicke von weniger als 10 nm hat.

5. Photovoltaikzelle nach einem der vorhergehenden Ansprüche, **dadurch gekennzeichnet, dass** sie ferner eine vierte amorphe Schicht (265) aus dem gleichen Halbleitermaterial wie das Substrat und vom gleichen ersten Leitfähigkeitstyp umfasst, wobei die vierte Schicht direkt auf der zweiten Fläche des Substrats (210) aufgebracht und durch die dritte Schicht bedeckt ist.

6. Photovoltaikzelle nach Anspruch 5, **dadurch gekennzeichnet, dass** die Dotierung in der dritten und der vierten Schicht graduell ist, wobei das Dotierungsniveau in eine Richtung zunimmt, die von der vierten Schicht zur dritten Schicht hin verläuft.

7. Photovoltaikzelle nach Anspruch 5, **dadurch gekennzeichnet, dass** das Dotierungsniveau in jeder der dritten und vierten Schicht konstant ist.

8. Photovoltaikzelle nach einem der Ansprüche 5 bis 7, **dadurch gekennzeichnet, dass** die dritte Schicht eine Dicke von weniger als 50 nm hat, und die vierte Schicht eine Dicke von weniger als 10 nm hat.

9. Photovoltaikzelle nach einem der vorhergehenden Ansprüche, **dadurch gekennzeichnet, dass** die erste Schicht durch eine erste transparente Oxid-Leiterschicht (230) bedeckt ist, auf der erste Sammelelektroden (240) angeordnet sind.

10. Photovoltaikzelle nach einem der vorhergehenden Ansprüche, **dadurch gekennzeichnet, dass** die dritte Schicht von einer zweiten transparenten Oxid-Leiterschicht (270) bedeckt ist, auf der zweite Sammelelektroden (280) angeordnet sind.

**Claims**

1. Photovoltaic cell comprising a heterojunction between a crystalline semiconductor substrate (210) of a first conductivity type and a first amorphous layer (220), on a first face of the substrate and in the same semiconductor material, said amorphous layer having a second conductivity type opposite the first and a dopant concentration of between $1.10^{19}$ and $1.10^{22}$ atoms/cm$^3$, the second face of the substrate opposite the first face being coated with a third amorphous layer (260) in the same material as the substrate and of the same conductivity type, with a dopant concentration of between $1.10^{19}$ and $1.10^{22}$ atoms/cm$^3$, **characterized in that** it further comprises a second amorphous layer (225) of same conductivity type as the first layer and having a dopant concentration of between $1.10^{16}$ and $1.10^{18}$ atoms/cm$^3$, said second layer being deposited directly on the first face of the substrate and being coated with said first layer.

2. Phohotovoltaic cell according to claim 1, **characterized in that** the doping in the first and second layers is gradual, the dopant concentration increasing in a direction leading from the second layer towards the first layer.

3. Photovoltaic cell according to claim 1, **characterized in that** the dopant concentration in each of the first and second layers is constant.

4. Photovoltaic cell according to any of the preceding claims, **characterized in that** the thickness of the first layer is less than 50 nm and the thickness of the second layer is less than 10 nm.

5. Photovoltaic cell according to any of the preceding claims, **characterized in that** it further comprises a fourth amorphous layer (265), in the same semiconductor material as the substrate and of the same conductivity type, said fourth layer being deposited directly on the second face of the substrate (210) and being coated with said third layer.

6. Photovoltaic cell according to claim 5, **characterized in that** the doping within the third and fourth layers is gradual, the dopant concentration increasing in a direction leading from the fourth layer towards the third layer.

7. Photovoltaic cell according to claim 5, **characterized in that** the dopant concentration in each of the third and fourth layers is constant.

8. Photovoltaic cell according to any of claims 5 to 7, **characterized in that** the thickness of the third layer is less than 50 nm and the thickness of the fourth layer is less than 10 nm.

9. Photovoltaic cell according to any of the preceding claims, **characterized in that** said first layer is coated with a first layer of transparent conductive oxide (230) on which first collecting electrodes (240) are arranged.

10. Photovoltaic cell according to any of the preceding claims, **characterized in that** said third layer is coated with a second layer of transparent conductive oxide (270) on which second collecting electrodes (280) are arranged.

**Fig. 1A**

**Fig. 1B**

240

230

220

225

210

260

270

280

**Fig. 2A**

240

230

220

225

210

265

260

270

280

**Fig. 2B**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 5213628 B
- US 5705828 B
- US 6670542 B
- EP 1320134 A